Europäisches Patentamt

European Patent Office

Office européen des brevets

(11) Publication number: **0 117 542 B1**

# EUROPEAN PATENT SPECIFICATION

(45) Date of publication of patent specification: **17.06.92**    (51) Int. Cl.5: **C23C 16/32**, C23C 16/34, C23C 16/36

(21) Application number: **84101936.7**

(22) Date of filing: **23.02.84**

(54) Chemical vapor deposition of metal compound coatings utilizing metal sub-halides.

(30) Priority: **25.02.83 US 469857**
**06.02.84 US 577225**

(43) Date of publication of application:
**05.09.84 Bulletin 84/36**

(45) Publication of the grant of the patent:
**17.06.92 Bulletin 92/25**

(84) Designated Contracting States:
**AT BE CH DE FR GB IT LI NL SE**

(56) References cited:
CH-A- 455 856          FR-A- 2 323 773
US-A- 3 637 422         US-A- 3 654 895
US-A- 3 721 577         US-A- 4 196 233

CHEMICAL ABSTRACTS, vol. 98, no. 6, 1983,
page 698, no. 45729j, Columbus, Ohio, US;
Y.SAEKI et al.: "Reaction process of vana-
dium tetrachloride with ammonia in the va-
por phase and properties of the vanadium
nitride formed" & BULL. CHEM. SOC. JPN.
1982, 55(11), 3446-9

PATENT ABSTRACTS OF JAPAN, vol. 7, no.
276 (E-215)[1421], 9th December 1983; & JP-

A-58 157 139 (FUJITSU K.K.) 19-09-1983

CHEMICAL ABSTRACTS, vol. 94, no. 13, June
1981, page 247, no. 212559e, Columbus,
Ohio, US; & JP-A-80 47 109 (FUJIKOSHI, LTD.)
27-11-1980

(73) Proprietor: **LIBURDI ENGINEERING LIMITED**
**3334 Mainway**
**Burlington Ontario L7M 1A7(US)**

(72) Inventor: **Hakim, Mohammed Javid**
**1786 Clifton Green**
**Burlington Ontario L7P 2X8(CA)**

(74) Representative: **Schütz, Peter, Dipl.-Ing. et al**
**Dr. Dieter von Bezold Dipl.-Ing. Peter Schütz**
**Dipl.-Ing. Wolfgang Heusler Brienner Strasse**
**52**
**W-8000 München 2(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 117 542 B1

**Description**

This invention relates to chemical vapor deposition of compounds of the titanium sub-group of elements and applies in addition to the vanadium sub-group and chromium sub-group of elements as coatings on a chosen substrate at low temperatures.

Such coatings can have various uses when applied to a substrate. For example, coatings of the titanium sub-groups are desirable on metalworking tools to increase the useful life of the tool. Others, such as niobium nitride coatings are useful as a super conductive material.

Depending upon the use to which the coating is to be put or the substrate on which the coating is put, the temperature at which a coating can be deposited may be important. Critical temperatures are often involved above which the properties of the substrate are altered.

For coating drills and machine tools with compounds of the titanium sub-group of elements to lengthen the useful life of the tool, nitrides, carbides and carbonitrides of titanium metal are desirable coatings. Compounds such as titanium nitride can be deposited as coatings by chemical vapor deposition (CVD) at temperatures of about 1000°C or higher.

However, most tool steels are hardened and tempered; and if temperatures exceeding the tempering temperatures are used, the tools lose their temper and must be re-heat treated. When re-heat treated, distortion becomes a problem and tool tolerances are affected. Thus, it is preferable to carry out any coating deposition at temperatures below the softening point of the tool metal in order to avoid affecting the temper of the tool steel.

The coating of metalworking tools with titanium nitride, is a typical example of a coating situation in which low temperature deposition of the coating is desirable. Present processes deposit titanium nitride by chemical vapor deposition by passing titanium tetrachloride, nitrogen and hydrogen over the substrate at temperatures of about 1000°C. or higher. Other existing processes, also operating in the range of 1000°C. add a hydrocarbon gas, such as methane, to include titanium carbide in the coating deposit. These temperatures have detrimental effects on tool steel temper. Re-heat treating to re-establish temper detrimentally affects tolerances. For example, tempered steel will lose hardness above 500° to 600°C., stainless steel will sensitize above 550°C. and nickel based super alloys overage above 600°C.

It has been found that low deposition temperatures below the temper temperatures of such metals can be used to deposit metal compound coatings of the type discussed above by utilizing sub-halide compounds of the metal in question in the deposition reaction. The phrase metal sub-halides refers to metal halides in which the metal exhibits a valency state (oxidation state) lower than the maximum valency state known for a halide of that metal. For example, the maximum valency for a halide of titanium is 4, i.e., $TiCl_4$. Therefore, the halide compounds of $TiCl_3$ and $TiCl_2$ where titanium exhibits a valency of $\overline{3}$ and 2, respectively, are titanium sub-halides and, in particular, titanium sub-chlorides. Similarly, where the maximum valency state of a halide of the metal is 5, any halide compound of that metal wherein the metal exhibits a valency state lower than 5, would be a sub-halide of that metal.

In Document CA-A- 1,087,041, the deposition of hafnium carbide and hafnium nitride coatings by chemical vapor deposition is discussed. At that time, temperatures typically in the neighborhood of 1,300°C. were required to produce hafnium coatings by chemical vapor deposition. That patent discloses the use of the sub-halides of hafnium in the deposition process, and thereby achieve temperatures as low as 900°C. in the deposition reaction. However, as discussed above, 900°C. is still above the temper loss point for many alloys that it is desirable to coat. The above discussed drawbacks of the prior art are avoided by a method of producing coatings of a metal nitride, or a metal carbide, or a metal carbonitride of at least one of the metals titanium, zirconium, hafnium, vanadium, niobium, tantalum, chromium, molybdenum and tungsten on a substrate by

a) reacting in a coating chamber in the presence of a substrate a gaseous mixture of the metal subhalides of at least one of said metals with one member of the groups of gaseous mixtures comprising hydrogen and nitrogen; hydrogen, nitrogen and ammonia; hydrogen and a hydrocarbon; hydrogen, nitrogen and a hydrocarbon; and hydrogen, nitrogen, ammonia and a hydrocarbon, and characterized according to the invention by the steps of:

b) manipulating the free energy value for the reaction and the kinetic parameters of the reaction by regulating the flow rates and the partial pressures of the reactant gases to facilitate in the coating chamber a reaction temperature in the range of 250 °C to less than 850 °C;

c) maintaining the reaction temperature of the substrate and the coating chamber in the said reaction temperature range, whereby a coating of a metal nitride, a metal carbide or a metal carbonitride is deposited on the substrate.

In a preferred embodiment, titanium nitride coatings have been produced on a substrate by passing a

2

EP 0 117 542 B1

controlled flow at about 400 volumes of hydrogen and about 10 volumes or hydrogen chloride over a bed of titanium metal particles heated to about 500°C., mixing 1000 volumes of hydrogen and 150 volumes of nitrogen with the resulting hydrogen and titanium chloride and passing the gaseous mixture over a substrate heated to about 600°C.

Further improvements and modifications in the process include mixing the nitrogen with the hydrogen before passing the mixture over the titanium metal particles and ammonia gas with the hydrogen and nitrogen mixture prior to introducing it to the substrate but continuing the addition of ammonia gas for a limited period of time. Further improvement and modification are obtained by varying the pressure of the gaseous mixture passed over the substrate and maintaining the pressure of the mixed gas around the substrate at a pressure not more than about 533 Pa. The selection of pressure is such as to produce Knudsen flow of the gas.

A thermodynamic analysis indicates that the lower halides (or sub-halides) of titanium, and in particular, titanium bichloride ($TiCl_2$), and titanium trichloride ($TiCl_3$) (subchlorides of titanium) facilitate a larger reaction negative-free energy value and accordingly a greater potential for reaction involving the deposition of TiN by CVD at low temperatures. Indeed, the potential of titanium bichloride and titanium trichloride to react with nitrogen and hydrogen in a gaseous environment to deposit titanium nitride continues to increase right down to 0 K. Nonetheless, reaction kinetics can inhibit the deposition of titanium nitride at low temperatures. However, it has been found that the potential for the reaction of $TiCl_2$ and $TiCl_3$ to form titanium nitride can be tapped in a vapor environment containing nitrogen and hydrogen using reaction temperatures in the range of 250°C. to 850°C. Although even lower coating temperatures are possible depending on deposition conditions used to overcome unfavorable kinetics, the temperatures used are intended to take full advantage of the favorable coating rates at a temperature which does not result in loss of temper or hardness in the tool substrates or item being coated. It is essential to keep the free energy of the reaction at or about a predetermined negative value in order that the temperature at which the reaction and the deposition of titanium nitride, in the case of titanium, takes place will be maintained in this temperature range.

In particular, the higher the equilibrium constant ($K_p$) of the reaction, the lower the reaction-free energy value will be, and accordingly, the partial pressure of the reactants and their flow rates are maintained at carefully controlled levels to permit the reaction to be carried out in the desired temperature range. In addition, the use of ammonia in the chemical vapor deposition stage assists in maintaining a higher equilibrium constant value and in enhancing the coating rates and quality.

Accordingly, titanium nitride is deposited by chemical vapor deposition by reacting titanium bichloride and/or titanium trichloride with hydrogen and nitrogen, and optionally some ammonia, at a suitable temperature that will not detrimentally affect substrate properties and using flow rates which maintain partial pressures of the reactants, $TiCl_2$ and $TiCl_3$, at relatively high levels. The favorable thermodynamics and kinetic factors are thereby utilized for the deposition of titanium nitride at the desirable temperature.

Titanium bichloride and titanium trichloride, because of their thermodynamic characteristics in reaction, are important ingredients in the reaction for the deposition of titanium nitride. Titanium bichloride and titanium trichloride can be produced by the reduction of titanium tetrachloride, but such reduction yields quantities of both that are smaller than are required to conduct the deposition of TiN at suitably high rates.

Titanium bichloride and titanium trichloride can, of course, be obtained from other sources and simply be fed to a chemical vapor deposition chamber for the production of titanium nitride. Alternatively, a second embodiment of the invention involves a preliminary in situ step for the production of titanium sub-chlorides by passing hydrogen chloride over titanium metal. Such reaction will produce titanium bichloride, titanium trichloride, and titanium tetrachloride and their relative proportions in the gas reaction mixture can be varied by manipulating the titanium metal chlorination conditions such as temperature or the partial pressures of hydrogen and the chlorinating agents such as hydrogen chloride.

To increase the concentration of $TiCl_2$ and $TiCl_3$, which are less volatile than $TiCl_4$, in the gas reaction mixture, the in situ chlorination of titanium metal and the deposition of TiN in the two stage process can also be conducted at low pressures. Reduction of pressure in the chlorination process facilitates vaporization of the sub-chlorides which have a higher vaporization temperature than $TiCl_4$. This, in turn, permits chlorination to be performed at a lower temperature which, in turn, promotes production of the sub-chlorides. The use of low pressures in the vicinity of 533 Pa pressure in the second stage of the process, that is the deposition of titanium nitride, also enhance the operation by improving the kinetic factors which favor deposition of titanium nitride on the substrate.

The invention will be better understood with reference to examples which follow and with reference to the following figures, in which:

Figure 1 shows the standard free energy versus temperature plots for the reactions of titanium

3

tetrachloride, $TiCl_4$, titanium trichloride, $TiCl_3$, and titanium bichloride, $TiCl_2$, with nitrogen and hydrogen to deposit titanium nitride, and;

Figure 2 shows the two-stage process to carry out the chemical vapor deposition of titanium nitride at low temperatures utilizing the sub-chlorides of titanium metal such as $TiCl_2$ and $TiCl_3$.

DESCRIPTION OF THE INVENTION

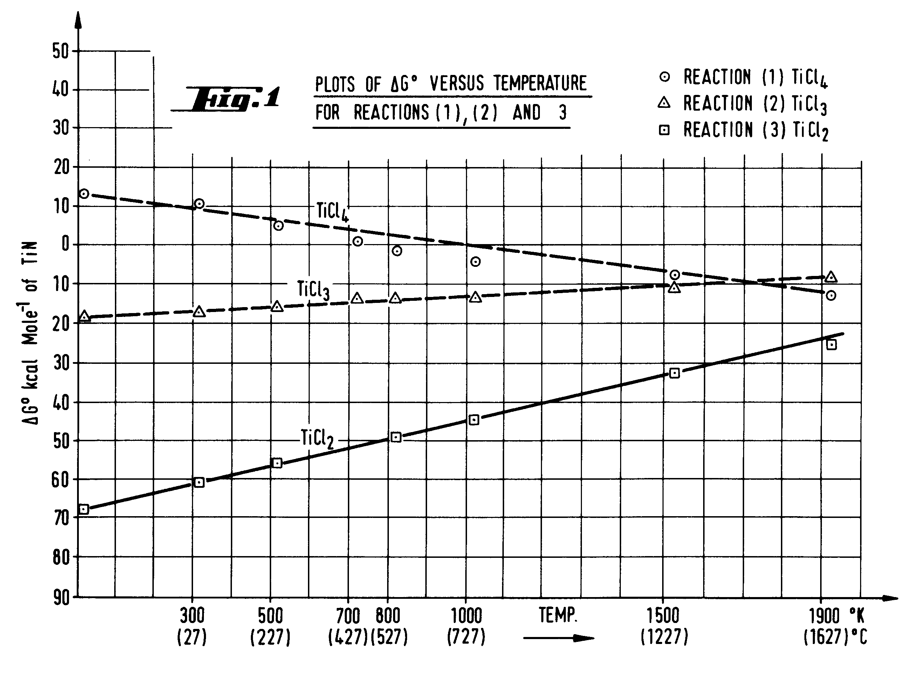

Figure 1 includes a thermodynamic evaluation of the potential reactions available in a CVD coating process using titanium chlorides and indicates what reactant is preferable for reaction in any desired temperature range. In particular, Figure 1 shows the standard free energy versus temperature plots for reactions 1, 2 and 3 below:

$$TiCl_{4(g)} + 1/2N_{2(g)} + 2H_{2(g)} \rightarrow TiN_{(s)} + 4HCl_{(g)} \qquad (1)$$
$$TiCl_{3(g)} + 1/2N_{2(g)} + 3/2H_{2(g)} \rightarrow TiN_{(s)} + 3HCl_{(g)} \qquad (2)$$
$$TiCl_{2(g)} + 1/2N_{2(g)} + H_{2(g)} \rightarrow TiN_{(s)} + 2HCl_{(g)} \qquad (3)$$

Figure 1 indicates the standard free energy values ($\Delta G°$) for these reactions at reaction temperatures ranging from -273°C. (0 K.) to 1627°C. (1900 K.) As indicated, the lower the free energy value the greater is the potential for reaction, although there is a point beyond which it is difficult to tap this potential due to unfavorable kinetics.

The plots in Figure 1 disclose that whereas $TiCl_4$ can be effective in depositing TiN at temperatures of 727°C. (1000 K.) and greater, $TiCl_3$ and $TiCl_2$ have potential for participating in the above reactions and depositing TiN at reactions temperatures down to -273°C. (0 K.). The potential for reaction of the latter compounds is due to the large negative free energy change accompanying reactions (2) and (3). The formation of TiN from $TiCl_2$ or $TiCl_3$ becomesmore favorable as the temperature is decreased. Nonetheless, at -273°C. (absolute 0 K.) any reaction would be very limited because of unfavorable kinetics. In addition, to trigger the reaction at any temperature requires manipulation of the physical process variables (i.e., kinetic variables), such as pressures and flow rates, and the thermodynamic values, such as the equilibrium constants (Kp), a key constituent in the free energy value of the reaction. Varying kinetic factors and thermodynamic values will result in the reaction occurring at different temperatures. This will be better understood in part by reference to the factors which control the free energy value and in particular the relation between the free energy value and in the equilibrium value (Kp). Table I lists the equilibrium constants (Kp) for the reactions (1), (2) and (3) at temperatures in the range of 27°C. to 1627°C.

TABLE I

| Temperature K(°C) | | Reaction (1) Kp | Reaction (2) Kp | Reaction (3) Kp |
|---|---|---|---|---|
| 300 | (27) | $1.1 \times 10^{-8}$ | $1.7 \times 10^{12}$ | $1.4 \times 10^{44}$ |
| 500 | (227) | $3.0 \times 10^{-3}$ | $7.3 \times 10^{6}$ | $1.2 \times 10^{24}$ |
| 700 | (427) | $2.6 \times 10^{-1}$ | $3.9 \times 10^{4}$ | $8.2 \times 10^{15}$ |
| 800 | (527) | 2.1 | $7.6 \times 10^{3}$ | $1.9 \times 10^{13}$ |
| 1,000 | (727) | 1.57 | $6.7 \times 10^{2}$ | $4.0 \times 10^{9}$ |
| 1,500 | (1227) | 10. | $3.3 \times 10$ | $5.1 \times 10^{4}$ |
| 1,900 | (1627) | 24.8 | 8.8 | $5.0 \times 10^{2}$ |

$K_p$ and $G°_T$ relate as follows - (using reaction 3 for illustration purposes):

$$(K_p)_T = \frac{(P-HCl)^2 \times (P-TiN)}{P-TiCl_2 \times (P-N_2)^{1/2} \times P-H_2} \qquad (4)$$

wherein P-HCl denotes the partial pressure of HCl at the reaction temperature T.

$$\Delta G°_T = -RT \ln (K_p)_T \qquad (5)$$

4

where R is the universal gas constant, T is the reaction temperature ln $(K_p)_T$ is the log to the base e of $(K_p)_T$.

As can be seen from equation (5) the free energy change $(\Delta G^\circ_T)$ is proportional to the negative of the equilibrium constant. Accordingly, the larger the equilibrium constant, the greater the negative value of free energy change and the greater the potential for reaction.

Therefore, from Figure 1, using $TiCl_3$, it will be seen that for $TiCl_3$ to participate in reaction (2) at a temperature of about 500°C., the free energy value needs to be in the range of - 603 kJ/per mole of TiN. With these free energy and temperature values, equation (5) then determines a fixed value for $K_p$ at that temperature and from this series of partial pressure combinations for the reactants of the reaction are available. In addition, as discussed further below, it has been found beneficial to introduce ammonia into the reaction of $TiCl_2$ and $TiCl_3$ in reactions (2) and (3) to enhance the rate of deposition of TiN.

Process apparatus for carrying out TiN deposition will now be described and will be followed by examples of deposition of TiN coatings on substrates at the desired reaction temperatures by varying and manipulating the process variables.

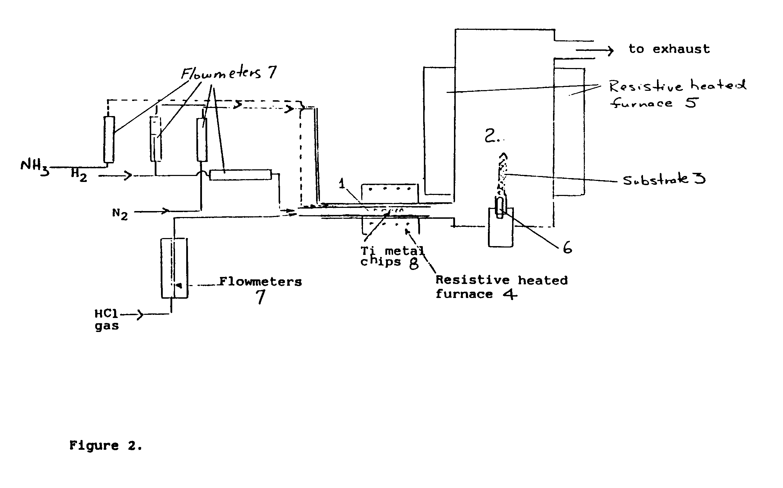

Figure 2 shows a process apparatus which comprises two basic reaction chambers, a first chlorination chamber 1 upstream of and connected integrally with a coating chamber 2. The chlorination chamber is heated by a conventional resistively heated furnace 4. The tool substrate 3 is mounted within the coating chamber 2 and the chamber 2 is heated using conventional resistive heating means 5. In addition and alternatively, the substrate 3 is independently heated in the coating chamber utilizing a conventional resistively heated cartridge heater 6.

In chamber 1, the resistance heated furnace 4 heats titanium Ti metal chips from 150°C. to 1100°C. and HCl and $H_2$ are fed through flow meters 7, passed over the heated titanium 8 to produce $TiCl_2$ and $TiCl_3$ and hydrogen in accordance with the following resultant reactions:

$$X \ HCl_{(g)} + Ti_{(s)} \longrightarrow TiCl_{(x)} + \frac{X}{2} H_2 \ (X = 2 \ or \ 3) \quad (6)$$

This reaction may also produce quantities of $TiCl_4$. However, the parameters of this reaction are controlled by using suitable combinations of reaction temperatures, and relative flow rates of $H_2$ and HCl to provide lower partial pressures of HCl, to steer the reaction towards predominant production of $TiCl_3$ and $TiCl_2$.

The $TiCl_2$ and $TiCl_3$ gases are carried by a carrier gas such as hydrogen or helium from chlorination chamber 1 to coating chamber 2 to which hydrogen and nitrogen are fed through flowmeters to foster reactions (2) and (3). Before reaching chamber 2, the hydrogen and nitrogen are preheated by passing through the furnace 4 in an annular chamber about reaction chamber 1. As discussed above, for the desired reactions (2) and (3) at a temperature in the range of 250°C. to 850°C. the value of Kp is fixed thermodynamically by formula (5) and a range of flow rates and partial pressure values can be determined. As will be appreciated, the flow rates chosen will affect the kinetics of the reaction. All the following examples are carried out on equipment of the type generally illustrated in Figure 2 and produced TiN coatings, and except where indicated otherwise the equipment is operated at atmospheric pressure.

TABLE II

| COATING CONDITIONS | | | |
|---|---|---|---|
| No. | Coating Temperature (°C.) | Flow rates (ml/min.) | |
| | Chamber 2 | $H_2$ | $N_2$ |
| 1 | 500 | 50 | 40 |
| 2 | 500 | 100 | 100 |
| 3 | 500 | 50 | 100 |
| 4 | 700 | 100 | 50 |
| 5 | 640 | 100 | 100 |
| 6 | 600 | 100 | 100 |
| 7 | 575 | 30 | 50 |
| 8 | 575 | 50 | 50 |
| 9 | 522 | 30 | 50 |
| 10 | 380 | 30 | 50 |
| 11 | 510 | 30 | 50 |
| 12* | 600 | 150 | 100 |
| 13 | 600 | 100 | 230 |
| 14 | 600 | 100 | 430 |
| 15 | 600 | 100 | 330 |
| 16 | 600 | 100 | 230 |
| 17 | 600 | 100 | 350 |
| 18 | 600 | 100 | 350 |
| 19 | 600 | 100 | 350 |
| 20 | 600 | 100 | 350 |
| 21 | 800 | 100 | 350 |

\* Deposition conducted at a total pressure of 546.6 Pa.

TABLE III

| CHLORINATION CONDITIONS | | | |
|---|---|---|---|
| No. | Reaction Temperature (°C.) | Flow Rates (ml/min.) | |
| | | H$_2$ | HCl |
| 1 | 500 | 150 | 5 |
| 2 | 500 | 200 | 8.5 |
| 3 | 750 | 300 | 10 |
| 4 | 800 | 50 | 10 |
| 5 | 800 | 300 | 15 |
| 6 | 850 | 300 | 15 |
| 7 | 800 | 200 | 10 |
| 8 | 800 | 200 | 10 |
| 9 | 800 | 200 | 10 |
| 10 | 800 | 200 | 10 |
| 11 | 800 | 200 | 10 |
| 12* | 600 | 150 | 5 |
| 13 | 600 | 600 | 12 |
| 14 | 600 | 1200 | 12 |
| 15 | 600 | 900 | 12 |
| 16 | 600 | 800 | 8 |
| 17 | 600 | 800 | 8 |
| 18 | 600 | 600 | 8 |
| 19 | 600 | 1200 | 8 |
| 20 | 600 | 400 | 8 |
| 21 | 650 | 800 | 8 |

* Chlorination conducted at a total pressure of 546.6 Pa.

It has been further found that the quality of the deposit and the rate of deposition of TiN in the above CVD reactions can be improved by the addition of ammonia to the gas reaction mixture. In the examples which follow, substrate materials such as copper, stainless steel and nickel based super alloy are independently heated in the coating chamber by mounting them on a cartridge heater. The temperature of the cartridge heater was controlled using a temperature controller. Temperatures of the copper, stainless steel and nickel based super alloy substrate materials are monitored using a separate thermocouple attached to their surfaces. The walls of the coating chamber are maintained at a constant temperature using the resistively heated furnace arrangement, as in the previous examples in Tables II and III. It is, of course, always important to have the coating chamber and its walls at a temperature high enough to keep the metal sub-halides in the gas phase and avoid any condensing-out at the walls.

A coating period of one hour and atmospheric operating pressure is used for all the coating runs summarized in Table IV. In all of the examples given in Table IV the same chlorination step in chamber 1 is conducted at 500°C. and at flow rates of 10 ml/min. of HCl and 400 ml/min. of H$_2$. Details of the deposition conditions used are given in Table IV.

From the previous examples relating to the use of ammonia, it can be seen from the results given in Table IV that ammonia is not only effective in enhancing the deposition of TiN thermodynamically as a comparison of the examples 1 with 4 shows; but also improves the kinetics of the deposition of TiN, as a comparison of the examples 3 with 1, 2, and 4 illustrates.

The examples shown in Table V illustrate the advantages of pressure reduction in the chamber where a coating is occurring and in the chlorination process. It will be seen in Table V, with a pressure in the coating chamber of 266.6 Pa and flow rates as shown and the addition of ammonia, good coatings are obtained. Table V also illustrates, in the third example, the effect of introducing the nitrogen in the first stage of the process during chlorination. Unexpectedly, the nitrogen does not result in nitrides being retained in the first reaction but permits a better control. In the third example with a flow rate of 20 millilitres of hydrogen and 6 millilitres of HCl and 20 millilitres of N$_2$ with the chamber pressure of 200 Pa (1.5 millimeters of mercury) a suitable coating could be obtained.

While Table V illustrates examples of operation at reduced pressure, it has been found that introduction of nitrogen in the first stage is also practical at atmospheric pressures.

A detailed description of the procedure used in coating with particular reference to the first example of Table V follows.

The apparatus is partially evacuated through the exhaust with all inlet gas flows shut off. The whole apparatus is flushed with a gas such as hydrogen or helium which is not reactive with other materials. Flushing is continued to rid the apparatus of water vapor and oxygen.

The temperature of the titanium is raised to 500°C. by furnace 4 and the temperature of substrate 3 is raised to 600°C. by heating means 5. These temperatures are measured by suitably located thermocouples.

The pressure within the apparatus is reduced. Hydrogen and hydrogen chloride at volume ratio of 40/12 is now permitted to flow over the titanium and hydrogen nitrogen and ammonia in the volume ratio of 20/10/3 are mixed with the resulting gases from the first stage.

The mixed gases flow into chamber 2 and a total pressure of about 266 Pa is maintained. The temperatures, gas flows and pressures are maintained for a suitable period of time, one hour for example.

At the end of the cycle the apparatus is permitted to cool down, the gas flow reverted to inert gas and the workpiece removed. Preferably the stage 1 portion of the apparatus is at least partially sealed off before the chamber 2 is opened to atmosphere thus simplifying the flushing process in the next cycle.

It will be understood that the above disclosure has dealt with TiN coatings only by way of example. The low temperature deposition principles disclosed above apply equally to the deposit of zirconium nitride, hafnium nitride, carbides and carbonitrides of titanium, zirconium and hafnium, nitrides, carbides and carbonitrides of vanadium, niobium and tantalum (the vanadium sub-group of metals) and of chromium molybdenum and tungsten (the chromium sub-group of metals). In fact, the invention applies to coatings of compounds of at least one of those metals of Group 4A, Group 5A and Group 6A because these metals have a variable valency and it is possible to use those valencies which have the lower free energy of formation when forming metallic halides. In the case of carbide coatings the reactant gases in the deposition reaction are a hydrocarbon such as $CH_4$, $H_2$ and the metal sub-halide. In the case of carbonitride coatings the reactant gases in the deposition reaction are hydrocarbon such as $CH_4$, $H_2$ and $N_2$ and/or $NH_3$ and the metal sub-halide. The substrates mentioned in this disclosure are exemplary, not exclusive. Other known substrates can be coated using the method and apparatus of this invention. Other known inert gas can be used.

TABLE IV

COATING CONDITIONS

| NO. | TEMPERATURE (°C) | | FLOW RATES (ml/min) | | | QUALITY OF TiN COATINGS |
|---|---|---|---|---|---|---|
| | Coating Chamber Walls | Substrate | $H_2$ | $N_2$ | $NH_3$ | |
| 1 | 400 | 600 ± 10 | 100 | 150 | ---- | A thin TiN coating was deposited |
| 2 | 400 | 600 ± 10 | 200 | 50 | 50 | Good, about 1/2 to 1 μ m thick |
| 3 | 400 | 600 ± 10 | 200 | 50 | 50* | Excellent, about 1/2 to 1 μ m thick. |
| 4 | 425 | 600 ± 10 | 200 | 50 | 5 | Good, about 1/2 to 1 μ m thick. |

\*    In No. 3, ammonia was allowed to flow only for the first five minutes of the total one hour duration of the coating run, after which it was turned off.

TABLE V

| Example No. | Chlorination Conditions (Stage 1) | | | | | Coating Conditions (Stage 2) | | | | Comments |
|---|---|---|---|---|---|---|---|---|---|---|
| | Temperature °C. | $H_2$ mL/min. | HCl | $N_2$ | Pressure Pa. | Temperature °C. | $H_2$ mL/min. | $N_2$ | $NH_3$ | |
| 1 | 500 | 40 | 12 | – | 266.6 | 600 | 20 | 10 | 3 | Good adherent coating of TiN, gold-color, about .5 microns thick. No detectable chlorine. |
| 2 | 500 | 25 | 6 | – | 133.3 | 600 | 20 | 10 | – | Similar to above. |
| 3 | 500 | 20 | 6 | 20 | 200 | 600 | 20 | – | – | Similar to above but thinner. Coating rate slightly reduced. |

While I have shown and described one embodiment in accordance with the present invention, it is understood that the same is not limited thereto but is susceptible of numerous changes and modifications as known to those skilled in the art, and I, therefore, do not wish to be limited to the details shown and described herein, but intend to cover all such changes and modifications as are encompassed by the appended claims.

**Claims**

1. A method of producing coatings of a metal nitride, or a metal carbide or a metal carbonitride of at least one of the metals titanium, zirconium, hafnium, vanadium, niobium, tantalum, chromium, molybdenum and tungsten on a substrate, said method comprising:

   a) reacting in a coating chamber in the presence of a substrate a gaseous mixture of the metal subhalides of at least one of said metals with one member of the groups of gaseous mixtures comprising hydrogen and nitrogen; hydrogen, nitrogen and ammonia; hydrogen and a hydrocarbon; hydrogen, nitrogen and a hydrocarbon; and hydrogen, nitrogen, ammonia and a hydrocarbon; characterized by the steps of:

   b) manipulating the free energy value for the reaction and the kinetic parameters of the reaction by regulating the flow rates and the partial pressures of the reactant gases to facilitate in the coating chamber a reaction temperature in the range of 250 °C to less than 850 °C;

   c) maintaining the reaction temperature of the substrate and the coating chamber in the said reaction temperature range, whereby a coating of a metal nitride, a metal carbide or a metal carbonitride is deposited on the substrate.

2. The method as claimed in claim 1, wherein the manipulated reaction temperature is in the range of 380 °C to 800 °C.

3. The method as claimed in claim 1 wherein the manipulated reaction temperature is in the range of 400 °C to 610 °C.

4. The method according to any of claims 1 to 3 further comprising producing a metal sub-halide by

   passing at least hydrogen halide over the metal in a reaction area,

   maintaining the reaction area in the temperature range of 150 °C to 1100 °C and

   controlling the flow of hydrogen halide over the metal to promote the production of metal sub-halide.

5. The method as claimed in claim 4, further comprising introducing hydrogen in said reaction area.

6. The method according to claims 4 or 5 further comprising introducing nitrogen gas into the process in the reaction area where the metal sub-halide is being produced.

7. The method according to any of claims 4 to 6 further comprising introducing ammonia into the coating chamber and into the gaseous mixture for a limited period of the time during the initial coating process.

8. The method as claimed in any of claims 1 to 6, wherein the gas reactants flow into said coating chamber continuously, the method comprising the additional step of including ammonia gas in the initial flow of gas reactants and terminating all flow of ammonia gas once said deposition has commenced.

9. The method as claimed in any of claims 4 to 8 in which said reaction area is maintained in the temperature range of 500 °C to 850 °C.

10. The method according to any of claims 1 to 9 for producing titanium nitride coatings on a substrate wherein said metal subhalides are titanium subchlorides and said gaseous mixture is a mixture of hydrogen, nitrogen and ammonia.

11. The method according to claim 1 for producing titanium nitride coatings on a substrate, characterized by

    passing a controlled flow of about 40 volumes of hydrogen and about 12 volumes of hydrogen chloride over a bed of titanium metal particles heated to about 500 °C;

    mixing 20 volumes of hydrogen and 10 volumes of nitrogen with the resulting hydrogen and titanium chloride gases;

    passing the gaseous mixture over a substrate heated to about 600 °C to obtain a titanium nitride coated substrate.

11

**12.** The method according to claim 11 further comprising maintaining the gaseous mixture surrounding the substrate at a pressure of not more than about 533 Pa.

**13.** The method according to claims 11 or 12 further comprising maintaining the gaseous mixture at a pressure such that Knudsen flow predominates.

**14.** The method according to any of claims 11 to 13 further comprising introducing ammonia into the coating chamber and into the gaseous mixture for a limited period of time during the initial coating process.

**15.** The method according to any of claims 1 to 14 wherein the substrate includes copper, stainless steel or nickel based super alloy.

**16.** A coated article consisting essentially of:
a substrate having a metal compound coating of metal nitride, metal carbide or metal carbonitride;
the metal being at least one of the metals from Group 4A, 5A and 6A of the Periodic Tables of the Elements, the metal compound coating being formed using a metal subhalide of at least one of said metals and using at least one of hydrogen, nitrogen, ammonia or methane;
**characterized in that** the substrate is made of copper, stainless steel, a nickel based super alloy, or a tool steel; and the metal compound coating is deposited on and adhered to, said substrate at a temperature below the softening point of said substrate and sufficiently low to avoid affecting the temper or hardness of the substrate.

**17.** The article according to claim 16 wherein the metal of the metal compound coating being titanium, zirconium, hafnium, vanadium, niobium, tantalum, chromium, molybdenum, tungsten or combination thereof.

**18.** The article according to claim 16, wherein the metal nitride being titanium nitride.

**19.** The article according to claim 16, wherein the metal compound coating being selected from zirconium nitride, hafnium nitride, carbides and carbonitrides of titanium, zirconium and hafnium, and nitrides, carbides and carbonitrides of vanadium, niobium, tantalum, chromium, molybdenum and tungsten.

**Revendications**

**1.** Procédé de production de revêtements d'un nitrure métallique, ou d'un carbure métallique, ou bien d'un carbonitrure métallique d'au moins l'un des métaux suivants : le titane, le zirconium, le hafnium, le vanadium, le niobium, le tantale, le chrome, le molybdène et le tungstène sur un substrat, ledit procédé comprenant les étapes consistant à :
a) faire réagir dans une chambre d'enduction en présence d'un substrat un mélange gazeux des sous-halogénures métalliques de l'un au moins desdits métaux sur un élément des groupes de mélanges gazeux comprenant l'hydrogène et l'azote ; l'hydrogène et l'ammoniac ; l'hydrogène et un hydrocarbure ; l'hydrogène, l'azote et un hydrocarbure ; et l'hydrogène, l'azote, l'ammoniac et un hydrocarbure ;

caractérisé par les stades suivants :
b) manipuler la valeur d'énergie libre pour la réaction et les paramètres cinétiques de la réaction en régulant les débits et les pressions partielles des gaz réactifs pour établir dans la chambre d'enduction une température supérieure ou égale à 250°C et inférieure à 850°C ;
c) maintenir la température de réaction du substrat et de la chambre d'enduction dans ledit intervalle de températures de réaction, de telle façon qu'un revêtement d'un nitrure métallique, d'un carbure métallique ou d'un carbonitrure métallique soit déposé sur le substrat.

**2.** Procédé selon la revendication 1, dans lequel la température de réaction manipulée est comprise entre 380°C et 800°C.

**3.** Procédé selon la revendication 1, dans lequel la température de réaction manipulée est comprise entre 400°C et 610°C.

**4.** Procédé selon l'une quelconque des revendications 1 à 3, comprenant en outre la production d'un sous-halogénure métallique en faisant passer au moins un acide halogènhydrique sur le métal dans une zone de réaction, maintenant la zone de réaction dans l'intervalle de température de 150°C à 100°C, et réglant l'écoulement de l'acide halogènhydrique sur le métal pour favoriser la production de sous-halogénure métallique.

**5.** Procédé selon la revendication 4, comprenant en outre l'introduction d'hydrogène dans ladite zone de réaction.

**6.** Procédé selon la revendication 4 ou 5, comprenant en outre l'introduction d'azote gazeux dans le processus dans la zone de réaction où le sous-halogènure métallique est en train d'être produit.

**7.** Procédé selon l'une quelconque des revendications 4 à 6, comprenant en outre l'introduction d'ammoniac dans la chambre d'enduction et dans le mélange gazeux pendant une période de temps limitée pendant le processus d'enduction initial.

**8.** Procédé selon l'une quelconque des revendications 1 à 6, dans lequel les réactifs gazeux pénètrent dans la chambre d'enduction en continu, le procédé comprenant l'étape additionnelle consistant à inclure de l'ammoniac gazeux dans le courant de réactifs gazeux initial et à achever la totalité de l'écoulement d'ammoniac gazeux, une fois que ledit dépôt à commencé.

**9.** Procédé selon l'une quelconque des revendications 4 à 8, dans lequel on maintient la zone de réaction dans l'intervalle de température de 500°C à 850°C.

**10.** Procédé selon l'une quelconque des revendications 1 à 9 pour produire des revêtements de nitrure de titane sur un substrat, dans lequel lesdits sous-halogènures métalliques sont des sous-chlorures de titane et ledit mélange gazeux est un mélange d'hydrogène, d'azote et d'ammoniac.

**11.** Procédé selon la revendication 1 pour produire des revêtements de nitrure de titane sur un substrat, caractérisé en ce que

l'on fait passer un écoulement réglé d'environ 40 volumes d'hydrogène et environ 12 volumes d'acide chlorhydrique sur un lit de particules de titane métallique chauffé à environ 500°C,

l'on mélange 20 volumes d'hydrogène et 10 volumes d'azote avec les gaz résultants : gaz chlorhydrique et chlorure de titane,

on fait passer le mélange gazeux sur un substrat chauffé à environ 600°C pour obtenir un substrat recouvert de nitrure de titane.

**12.** Procédé selon la revendication 11, comprenant en outre le maintien du mélange gazeux entourant le substrat à une pression ne dépassant par environ 533 Pa.

**13.** Procédé selon la revendication 11 ou 12, comprenant en outre le maintien du mélange gazeux à une pression telle que l'écoulement de Knudsen soit prédominant.

**14.** Procédé selon l'une quelconque des revendications 11 à 13, comprenant en outre l'introduction d'ammoniac dans la chambre d'enduction et dans le mélange gazeux pendant une période de temps limitée au cours du processus d'enduction initial.

**15.** Procédé selon l'une quelconque des revendications 1 à 14, dans lequel le substrat comprend un superalliage à base de cuivre, d'acier inoxydable ou de nickel.

**16.** Article à revêtement comprenant essentiellement :

un substrat ayant un revêtement de composé métallique en nitrure métallique, en carbure métallique ou carbonitrure métallique, le métal étant au moins l'un des métaux du groupe 4A, 5A et 6A de la classification périodique des éléments, le revêtement en composé métallique étant formé en utilisant un sous-halogénure métallique d'au moins l'un desdits métaux et en utilisant au moins l'un des corps suivants : l'hydrogène, l'azote, l'ammoniac ou le méthane,

caractérisé en ce que le substrat est en cuivre, en acier inoxydable, en un super alliage à base de nickel ou un acier à outils ; et que le revêtement en composé métallique est déposé sur ledit substrat et y adhère à une température inférieure au point de fusion dudit substrat et suffisamment basse pour éviter d'affecter la trempe ou la dureté du substrat.

**17.** Article selon la revendication 16 dans lequel le métal du revêtement en composé métallique est le titane, le zirconium, le hafnium, le vanadium, le niobium, le tantale, le chrome, le molybdène, le tungstène ou une combinaison de ceux-ci.

**18.** Article selon la revendication 16 dans lequel le nitrure métallique est le nitrure de titane.

**19.** Article selon la revendication 16 dans lequel le revêtement en composé métallique est choisi parmi le nitrure de zirconium, le nitrure de hafnium, les carbures et les carbonitrures de titane, de zirconium et de hafnium, et les nitrures, les carbures et les carbonitrures de vanadium, de niobium, de tantale, de chrome, de molybdène et de tungstène.

**Patentansprüche**

**1.** Verfahren zum Herstellen von Schichten aus einem Metallnitrid oder einem Metallcarbid oder einem Metallcarbonitrid mindestens eines der Metalle Titan, Zirconium, Hafnium, Vanadium, Niob, Tantal, Chrom, Molybdän und Wolfram auf einem Substrat, bei welchem

a) eine Gasmischung von Sub-Halogeniden mindestens eines der genannten Metalle in einer Beschichtungskammer in Gegenwart eines Substrats mit einem Vertreter der Gruppe von Gasmischungen, die Wasserstoff und Stickstoff; Wasserstoff, Stickstoff und Ammoniak; Wasserstoff und Kohlenwasserstoff; Wasserstoff, Stickstoff und Kohlenwasserstoff; und Wasserstoff, Stickstoff, Ammoniak und Kohlenwasserstoff enthält, zur Reaktion gebracht wird,

**dadurch gekennzeichnet**, daß

b) der Wert der freien Energie für die Reaktion und die kinetischen Parameter der Reaktion durch Regelung der Strömungsraten und der Partialdrücke der Reaktionsgase so manipuliert werden, daß in der Beschichtungskammer eine Reaktionstemperatur im Bereich von 250°C bis weniger als 850°C gefördert wird; und

c) die Reaktonstemperatur des Substrats und der Beschichtungskammer in dem genannten Reaktionstemperaturbereich aufrechterhalten wird, wodurch eine Schicht eines Metallnitrides, eines Metallcarbides oder eines Metallcarbonitrides auf dem Substrat niedergeschlagen wird.

**2.** Verfahren nach Anspruch 1, **dadurch gekennzeichnet**, daß die manipulierte Reaktionstemperatur im Bereich von 380°C bis 800°C liegt.

**3.** Verfahren nach Anspruch 1, **dadurch gekennzeichnet**, daß die manipulierte Reaktionstemperatur im Bereich von 400°C bis 610°C liegt.

**4.** Verfahren nach einem der Ansprüche 1 bis 3, **dadurch gekennzeichnet**, daß ein Metall-Subhalogenid dadurch erzeugt wird, daß

mindestens ein Halogenwasserstoff in einem Reaktionsbereich über das Metall geleitet wird, der Reaktionsbereich im Temperaturbereich von 150°C bis 1100°C gehalten wird und die Strömung des Halogenwasserstoffes über das Metall gesteuert wird, daß die Erzeugung des Metall-Subhalogenides gefördert wird.

**5.** Verfahren nach Anspruch 4, **dadurch gekennzeichnet**, daß Wasserstoff in den Reaktionsbereich eingeführt wird.

**6.** Verfahren nach Anspruch 4 oder 5, **dadurch gekennzeichnet**, daß Stickstoffgas in den Prozess im Reaktionsbereich eingeführt wird, wo das Metall-Subhalogenid erzeugt wird.

**7.** Verfahren nach den Ansprüchen 4 bis 6, **dadurch gekennzeichnet**, daß Ammoniak für eine begrenzte Zeitspanne während des anfänglichen Beschichtungsprozesses in die Beschichtungskammer und in die Gasmischung eingeführt wird.

8. Verfahren nach einem der Ansprüche 1 bis 6, bei dem die Reaktionsgase kontinuierlich in die Beschichtungskammer strömen, **gekennzeichnet durch** den zusätzlichen Verfahrensschritt, Ammoniakgas in den anfänglichen Strom von Reaktionsgasen einzuführen und die ganze Ammoniakgasströmung zu beenden, nach dem das Niederschlagen eingesetzt hat.

9. Verfahren nach einem der Ansprüche 4 bis 8, **dadurch gekennzeichnet**, daß der Reaktionsbereich im Temperaturbereich von 500°C bis 850°C gehalten wird.

10. Verfahren nach einem der Ansprüche 1 bis 9, zur Herstellung von Titannitridschichten auf einem Substrat, **dadurch gekennzeichnet**, daß die Metall-Subhalogenide Titan-Subchloride sind und daß die Gasmischung eine Mischung aus Wasserstoff, Stickstoff und Ammoniak ist.

11. Verfahren nach Anspruch 1 zum Herstellen von Titannitrid-Schichten auf einem Substrat, **dadurch gekennzeichnet**, daß

ein gesteuerter Strom von etwa 40 Volumenteilen Wasserstoff und etwa 12 Volumenteilen Chlorwasserstoff über ein Bett von auf etwa 500°C erhitzten Titanmetallteilchen geleitet wird;

20 Volumenteile Wasserstoff und 10 Volumenteile Stickstoff mit den resultierenden Wasserstoff- und Titanchloridgasen gemischt wird;

die Gasmischung über ein Substrat geleitet wird, das auf etwa 600°C erhitzt ist, um ein mit Titannitrid beschichtetes Substrat zu erhalten.

12. Verfahren nach Anspruch 11, **dadurch gekennzeichnet**, daß die das Substrat umgebende Gasmischung auf einem Druck von nicht mehr als etwa 533 Pa gehalten wird.

13. Verfahren nach Anspruch 11 oder 12, **dadurch gekennzeichnet**, daß die Gasmischung auf einem solchen Druck gehalten wird, daß überwiegend Knudsen-Strömung vorliegt.

14. Verfahren nach einem der Ansprüche 11 bis 13, **dadurch gekennzeichnet**, daß Ammonik für eine begrenzte Zeitspanne während des anfänglichen Beschichtungsprozesses in die Beschichtungskammer und in die Gasmischung eingeführt wird.

15. Verfahren nach einem der Ansprüche 1 bis 14, **dadurch gekennzeichnet**, daß das Substrat Kupfer, nichtrostenden Stahl oder eine Superlegierung auf Nickelbasis enthält.

16. Beschichteter Gegenstand, der im wesentlichen aus einem Substrat mit einer Metallverbindungsbeschichtung aus einem Metallnitrid, Metallcarbid oder Metallcarbonitrid besteht, wobei es sich bei dem Metall um mindestens eines der Metalle aus den Gruppen 4A, 5A und 6A des Periodensystems der Elemente handelt und die Metallverbindungsbeschichtung unter Verwendung eines Metall-Subhalogenides mindestens eines der genannten Metalle unter Verwendung-von Wasserstoff und/oder Stickstoff und/oder Ammoniak und/oder Methan gebildet ist, **dadurch gekennzeichnet**, daß das Substrat aus Kupfer, nichtrostendem Stahl, einer Superlegierung auf Nickelbasis oder Werkzeugstahl besteht und daß die Metallverbindungsbeschichtung bei einer Temperatur auf dem Substrat niedergeschlagen und zum Haften gebracht ist, die unterhalb des Erweichungspunktes des Substrates liegt und so niedrig ist, daß die Vergütung oder Härte des Substrats nicht beeinträchtigt wird.

17. Gegenstand nach Anspruch 16, bei welchem das Metall der Metallverbindungsbeschichtung Titan, Zirkonium, Hafnium, Vanadium, Niob, Tantal, Chrom, Molybdän, Wolfram oder eine Kombination hiervon ist.

18. Gegenstand nach Anspruch 16, **dadurch gekennzeichnet**, daß Metallnitrid Titannitrid ist.

19. Gegenstand nach Anspruch 16, **dadurch gekennzeichnet**, daß die Metallverbindungsbeschichtung ausgewählt ist aus Zirconiumnitrid, Hafniumnitrid, Carbiden und Cabonitriden des Titans, des Zirconiums und des Hafniums und Nitriden, Carbiden und Carbonitriden des Vanadiums, Niobs, Tantals, Chroms, Molybdäns und Wolframs.

**Fig.1** PLOTS OF ΔG° VERSUS TEMPERATURE FOR REACTIONS (1),(2) AND 3

⊙ REACTION (1) TiCl$_4$
△ REACTION (2) TiCl$_3$
□ REACTION (3) TiCl$_2$

TiCl$_4$

TiCl$_3$

TiCl$_2$

ΔG° kcal Mole$^{-1}$ of TiN

TEMP.

300 (27)  500 (227)  700 (427) 800 (527)  1000 (727)  1500 (1227)  1900 °K (1627)°C

EP 0 117 542 B1

Flowmeters 7

NH$_3$

H$_2$

N$_2$

HCl gas

Flowmeters 7

1

Ti metal chips 8

Resistive heated furnace 4

to exhaust

Resistive heated furnace 5

2.

Substrate 3

6

Figure 2.

EP 0 117 542 B1